Europäisches Patentamt

European Patent Office (11) Numéro de publication: **0 169 082**

Office européen des brevets **A1**

(12) # DEMANDE DE BREVET EUROPEEN

(21) Numéro de dépôt: **85400843.0**

(51) Int. Cl.⁴: **H 01 L 21/90,** H 01 L 23/52

(22) Date de dépôt: **29.04.85**

(30) Priorité: **11.05.84 FR 8407294**

(43) Date de publication de la demande: **22.01.86**
**Bulletin 86/4**

(84) Etats contractants désignés: **DE FR GB IT NL**

(71) Demandeur: **SOCIETE POUR L'ETUDE ET LA FABRICATION DE CIRCUITS INTEGRES SPECIAUX - E.F.C.I.S., 17, avenue des Martyrs, F-38100 Grenoble (FR)**

(72) Inventeur: **Payo-Casares, André, THOMSON-CSF SCPI 173, bld Haussmann, F-75379 Paris Cedex 08 (FR)**

(74) Mandataire: **Guérin, Michel et al, THOMSON-CSF SCPI 173, Bld Haussmann, F-75379 Paris Cédex 08 (FR)**

(54) Procédé de fabrication de circuits intégrés à plusieurs niveaux d'interconnexion en tungstène.

(57) L'invention concerne la réalisation d'interconnexions sur plusieurs niveaux dans les circuits intégrés.

Dans le procédé décrit, les interconnexions sont en tungstène sur deux niveaux (16 et 24) et, pour protéger le premier niveau (16) lors de la gravure du second niveau (24), on dépose entre les deux niveaux de tungstène une couche mince (17 ou 22) d'aluminium. Cette couche est déposée soit immédiatement après le dépôt du premier niveau de tungstène (couche 17) soit immédiatement avant le dépôt du deuxième niveau de tungstène (couche 22).

# PROCEDE DE FABRICATION DE CIRCUITS INTEGRES A PLUSIEURS NIVEAUX D'INTERCONNEXION EN TUNGSTENE

La présente invention se rapporte au domaine des circuits intégrés, et elle concerne plus précisément les étapes de fabrication dans lesquelles on réalise des interconnexions métalliques entre les divers éléments (notamment les transistors) formés à la surface ou dans le volume d'un substrat de circuit intégré.

On cherche de plus en plus à réaliser plusieurs niveaux successifs d'interconnexions de manière à augmenter la complexité des circuits qu'on peut intégrer sur une surface donnée. Ainsi, une première couche d'interconnexion métallique est déposée, et gravée selon un premier motif d'interconnexions entre des éléments de circuit réalisés auparavant ; puis, une couche isolante est déposée et gravée pour ouvrir des fenêtre d'accès ponctuel à la première couche ; enfin, une deuxième couche métallique est déposée et gravée selon un deuxième motif d'interconnexion.

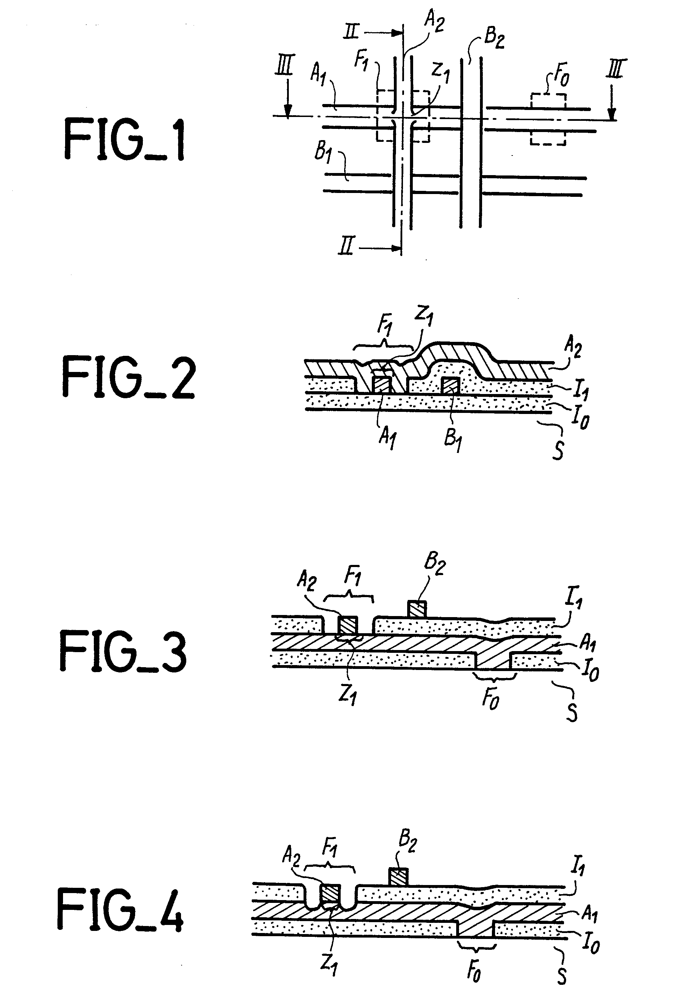

La figure 1 représente symboliquement, en vue de dessus, deux conducteurs de ligne A1 et B1 d'une première couche d'interconnexion, et deux conducteurs de colonne A2 et B2 d'une deuxième couche d'interconnexion. Les conducteurs A1 et A2 se croisent et sont en contact l'un avec l'autre dans une zone de contact Z1 à l'endroit du croisement. Par contre, le conducteur A2 est isolé du conducteur B1 à l'endroit où il le croise ; de même, le conducteur B2 est isolé du conducteur A1 comme du conducteur B1 là où il les croise.

Entre les conducteurs A2, B2 de la deuxième couche d'inter-connexion et les conducteurs A1, B1 de la première couche, on trouve une couche d'isolant I1 sauf dans une fenêtre F1 qui contient la zone de contact Z1 entre les conducteurs A1 et A2.

On peut imaginer à titre d'exemple que le conducteur A1 repose généralement sur une couche d'isolant I0 recouvrant le substrat S, sauf dans une fenêtre F0 où la couche d'isolant I0 est

ouverte et où le conducteur A1 est en contact avec une zone semiconductrice du substrat S (source ou drain d'un transistor par exemple).

La figure 2 et la figure 3 représentent en coupe verticale la structure qui résulte de la description qui précède. La figure 2 est une coupe selon la ligne II-II de la figure 1, c'est-à-dire le long du conducteur de colonne A2 ; la figure 3 est une coupe selon la ligne III-III de la figure 1, c'est-à-dire le long du conducteur de ligne A1.

Afin de maximiser la surface de contact en minimisant le pas (largeur plus espacement) des lignes et colonnes conductrices, et pour des raisons de précision de positionnement de la fenêtre F1 au carrefour des conducteurs A1 et A2, on est amené à prévoir que cette fenêtre a des dimensions, largeur et longueur, supérieures à la largeur des conducteurs A1 et A2.

Il en résulte des défauts de fabrication qui vont être expliqués ci-après en exposant le procédé de fabrication de la structure décrite aux figures 1 à 3 : ayant réalisé des éléments semiconducteurs intégrés dans un substrat S, on recouvre ce substrat d'une couche isolante IO, par exemple en oxyde de silicium ; on grave cette couche pour ouvrir les fenêtres FO là où l'on doit réaliser un contact avec un élément du substrat sous-jacent, par exemple un transistor ; on dépose une première couche métallique d'interconnexion que l'on grave pour former un premier motif d'interconnexion désiré (lignes A1 et B1) ; on dépose une autre couche isolante I1 (oxyde de silicium par exemple) ; on la grave pour ouvrir des fenêtres F1 englobant des zones de contact Z1 désirées, les fenêtres F1 étant plus larges que ces zones Z1 ; on dépose alors la deuxième couche métallique d'interconnexion, que l'on grave pour former un deuxième motif d'interconnexion désiré (lignes A2 et B2).

Dans une réalisation préférée, les couches d'interconnexion sont en tungstène qui a l'avantage,

- de présenter un grain très fin (donc une possibilité de gravure précise),

3

- de présenter un faible taux d'électro-migration (déplacement d'ions métalliques sous l'effet des champs et courants présents pendant le fonctionnement du circuit, cette électro-migration créant des zones d'accumulation ou des zones de rétrécissement des conducteurs),

- d'avoir une faible résistivité (5,3 micro-ohms-cm), et

- de pouvoir être déposé par décomposition chimique en phase gazeuse.

Malheureusement, lors de la gravure de la deuxième couche de tungstène, on se heurte à la difficulté suivante : on cherche à graver le tungstène par gravure sèche (gravure par plasma ou gravure ionique réactive) qui, du fait de sa directivité (gravure anisotrope verticale), est beaucoup plus précise qu'une gravure chimique ; mais on contrôle mal la profondeur de cette gravure et le tungstène de la ligne A1, mis à nu dans la fenêtre F1, risque d'être attaqué partiellement à la fin de la gravure des lignes A2, B2. Ceci résulte de ce que la largeur de la fenêtre F1 est plus grande que la largeur du conducteur A2.

On risque en fait d'aboutir à une structure qui, au lieu d'être celle de la figure 3, est plutôt celle de la figure 4 où le conducteur A1 est partiellement, voire totalement, coupé de part et d'autre de la zone de contact avec le conducteur A2 dans la fenêtre F1. Une coupure totale est évidemment rédhibitoire, mais même une coupure partielle est gênante car elle entraîne une réduction de la section de passage du courant préjudiciable au bon fonctionnement des circuits.

Pour remédier à cet inconvénient, il s'est avéré nécessaire en général de faire en sorte que le conducteur A2 soit élargi au niveau du contact Z1 à une dimension supérieure à celle de la fenêtre F1, mais cela entraîne une augmentation de la distance minimale de garde à prévoir entre les lignes adjacentes de conducteurs d'un motif d'interconnexion, donc une réduction de la densité d'intégration.

La présente invention propose un procédé de fabrication de circuits intégrés à au moins deux niveaux d'interconnexion métalliques présentant entre eux des zones de contact ponctuelles, ce

4

procédé comprenant des étapes analogues à celles qui ont été décrites en référence aux figures 1 à 4, à savoir :

a) dépôt d'une première couche d'interconnexion constituée essentiellement par du tungstène,

b) gravure sèche sélective de la première couche, à travers un masque ouvert selon un motif d'interconnexion désiré,

c) dépôt d'une couche isolante,

d) gravure de cette couche isolante pour ouvrir des fenêtres à l'endroit des zones de contact désirées, les fenêtres étant plus larges que les zones de contact,

e) dépôt d'une deuxième couche d'interconnexion constituée essentiellement par du tungstène,

f) gravure sèche sélective, à partir d'un composé fluoré, de la deuxième couche, à travers un masque ouvert selon un autre motif d'interconnexion désiré.

Le procédé selon l'invention comporte de plus, entre les étapes a) et e), le dépôt d'une couche mince d'aluminium. Selon un premier mode de réalisation le dépôt d'aluminium est effectué entre les étapes d) et e), à savoir après la gravure des fenêtres de la couche isolante et avant le dépôt de la deuxième couche de tungstène. La deuxième couche de tungstène est gravée au moyen d'un composé fluoré ; l'aluminium qui subsiste après cette gravure est alors éliminé là où il n'est pas recouvert de tungstène, sans opération de masquage (ou avec le même masque qui vient de servir pour la gravure de la deuxième couche), au moyen d'un produit d'attaque relativement sélectif par rapport au tungstène et au matériau constituant la couche isolante. Dans une autre variante de réalisation, le dépôt d'aluminium est effectué après le dépôt, mais avant la gravure, de la première couche de tungstène. Cette gravure, à travers un masque définissant le premier motif d'interconnexion, est alors immédiatement précédée d'une gravure sèche de l'aluminium, à travers le même masque et au moyen d'un composé chloré.

Par "gravure sèche", on entend dans la présente description

5

une gravure qui ne s'effectue pas dans un bain chimique mais dans un bâti de gravure par plasma ou de gravure ionique réactive.

D'autres caractéristiques et avantages de l'invention apparaîtront à la lecture de la description détaillée qui suit et qui est faite en référence aux dessins annexés dans lesquels :

- les figures 1 à 4 déjà décrites, représentent une structure d'interconnexions à deux niveaux de la technique antérieure,

- les figures 5 à 9 représentent une première variante du procédé de fabrication selon l'invention,

- les figures 10 à 13 représentent une seconde variante du procédé selon l'invention.

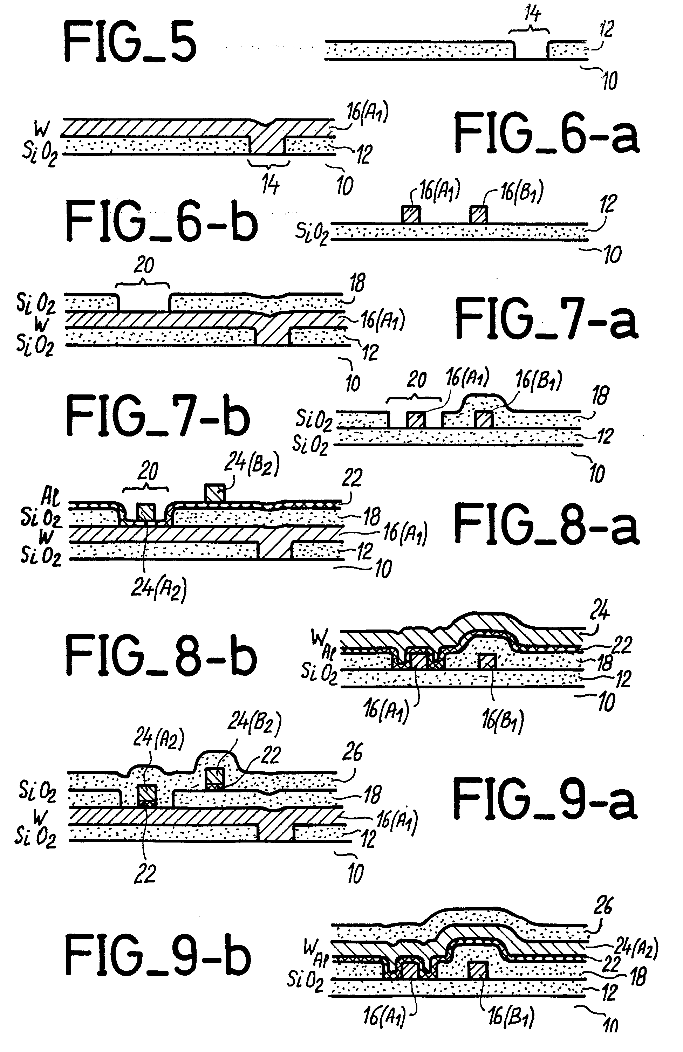

Sur la figure 5, on a représenté un substrat 10 qui peut être un substrat de silicium dans lequel on a réalisé un certain nombre d'éléments de circuit non représentés, et notamment des transistors. La surface supérieure de ce substrat a été représentée plane pour simplifier, mais il faut comprendre qu'elle peut être fortement modelée par les circuits sous-jacents.

On recouvre cette surface d'une couche isolante 12, par exemple en oxyde de silicium déposé à basse pression ou en nitrure de silicium ou un composé d'oxyde et de nitrure, sur laquelle reposera ultérieurement la première couche d'interconnexion.

On grave cette couche isolante 12 pour ouvrir des fenêtres 14 là où une première couche d'interconnexion métallique devra venir en contact avec des éléments de circuit sous-jacents à la couche 12 (figure 5).

On dépose, par pulvérisation dans un bâti prévu à cet effet, une couche métallique à base de tungstène 16 (tungstène pur ou alliage comportant essentiellement du tungstène : titane-tungstène par exemple) ; l'épaisseur de la couche 16 est de l'ordre du micron ou moins.

On peut aussi déposer le tungstène par décomposition chimique en phase gazeuse dans un bâti approprié, à basse pression ou à la pression atmosphérique.

6

On grave cette couche 16 de tungstène dans un bâti de gravure sèche (gravure anisotrope verticale au plasma ou gravure ionique réactive, à partir d'un composé fluoré tel que le fluorure de soufre $SF_6$ ou de carbone $CF_4$, éventuellement additionnés d'oxygène) après masquage par une résine inattaquable par le produit d'attaque utilisé. Le masquage de résine définit le motif d'interconnexions du premier niveau d'interconnexion du circuit. On suppose ici que le motif comprend des lignes parallèles A1 et B1 comme à la figure 1 et que la figure 6a représente une section longitudinale du circuit le long de la ligne A1, la figure 6b représentant une section transversale, coupant cette ligne.

On dépose alors, par décomposition chimique en phase vapeur et à basse pression, une couche isolante 18 (oxyde de silicium, nitrure de silicium ou un composé des deux) qui servira à isoler l'un par rapport à l'autre les deux niveaux d'interconnexion métallique prévus.

On grave la couche isolante 18 après masquage par une résine, pour ouvrir des fenêtres 20 dans lesquelles le tungstène de la couche 16 est mis à nu là où on désire un contact entre les deux niveaux d'interconnexion métallique. La largeur des fenêtres 20 est supérieure (au moins pour certains des contacts prévus) à la largeur des lignes du métal de la première couche, ainsi qu'à celle des lignes du métal de la deuxième couche, comme cela est représenté à la figure 1 à propos de la fenêtre F1 et des conducteurs A1 et A2 : il s'agit de fenêtres débordant tout autour des zones effectives de contact entre lignes et colonnes. On rappelle que ces fenêtres sont prévues suffisamment larges pour être sûr que malgré la dispersion de positionnement entre les trois masques successifs définissant respectivement le premier motif d'interconnexion, les fenêtres 20, et le deuxième motif d'interconnexion, il n'y ait pas de risque que la zone de contact finale entre deux conducteurs soit réduite par rapport à celle que permet un positionnement parfaitement aligné entre ces trois masques ; la structure qui en résulte est représentée aux figures 7a et 7b (correspondant respectivement aux sections longitudinale et transversale des figures 6a et 6b).

On dépose alors, par pulvérisation ou par décomposition chimique dans un bâti approprié, une couche mince 22 d'aluminium (0,1 à 0,5 microns par exemple), ou d'un alliage à base d'aluminium (aluminium-silicium notamment), et ce dépôt est suivi immédiatement, dans le même bâti, du dépôt d'une deuxième couche 24 de tunsgtène (de l'ordre de un micron d'épaisseur) ou d'un alliage à base de tungstène (titane-tungstène). Cette deuxième couche est gravée, en gravure sèche anisotrope verticale, au moyen d'un composé fluoré ($SF_6$ ou $CF_4$ éventuellement additionnés d'oxygène) après masquage par une résine insensible à ce produit, le masque définissant le motif d'interconnexion de la deuxième couche (colonnes parallèles A2 et B2 sur les figures 8a et 8b qui sont des sections longitudinale et transversale correspondant aux figures 7a et 7b). Le conducteur A2 coupe le conducteur A1 à l'intérieur d'une fenêtre 20. Sur la figure 8b, on suppose que la coupe transversale effectuée se situe le long d'un conducteur de colonne A2.

L'aluminium 22 n'est pas attaqué pendant cette gravure au moyen d'un composé fluoré, de sorte qu'il protège contre une surgravure le tungstène de la première couche 16 dans la fenêtre 20.

On peut alors éliminer l'aluminium partout où il est mis à nu, c'est-à-dire là où il n'est pas protégé par le tungstène du deuxième niveau d'interconnexion, par gravure sèche au moyen d'un composé chloré, par exemple du chlorure de carbone $CCl_4$ ou de bore $BCl_3$ ou du chlore $Cl_2$, sans opération de masquage supplémentaire. Le tungstène est relativement peu attaqué par ces composés. On peut aussi envisager, étant donné la faible épaisseur d'aluminium présente, d'éliminer la couche 22 par gravure dans un bain chimique n'attaquant ni le tungstène ni la couche isolante 18, par exemple un bain contenant du $H_3PO_4$.

Il subsiste, à la fin de ces étapes, une structure à deux niveaux d'interconnexions dans laquelle le deuxième niveau est constitué

8

partout par une double couche : couche inférieure mince d'aluminium 22 et couche supérieure plus épaisse 24 de tungstène (figure 9a et 9b). Cette structure peut à nouveau être recouverte d'une couche isolante 26 de passivation ou d'une couche isolante servant à séparer le deuxième niveau d'interconnexion d'un troisième niveau réalisé de la même manière que le deuxième.

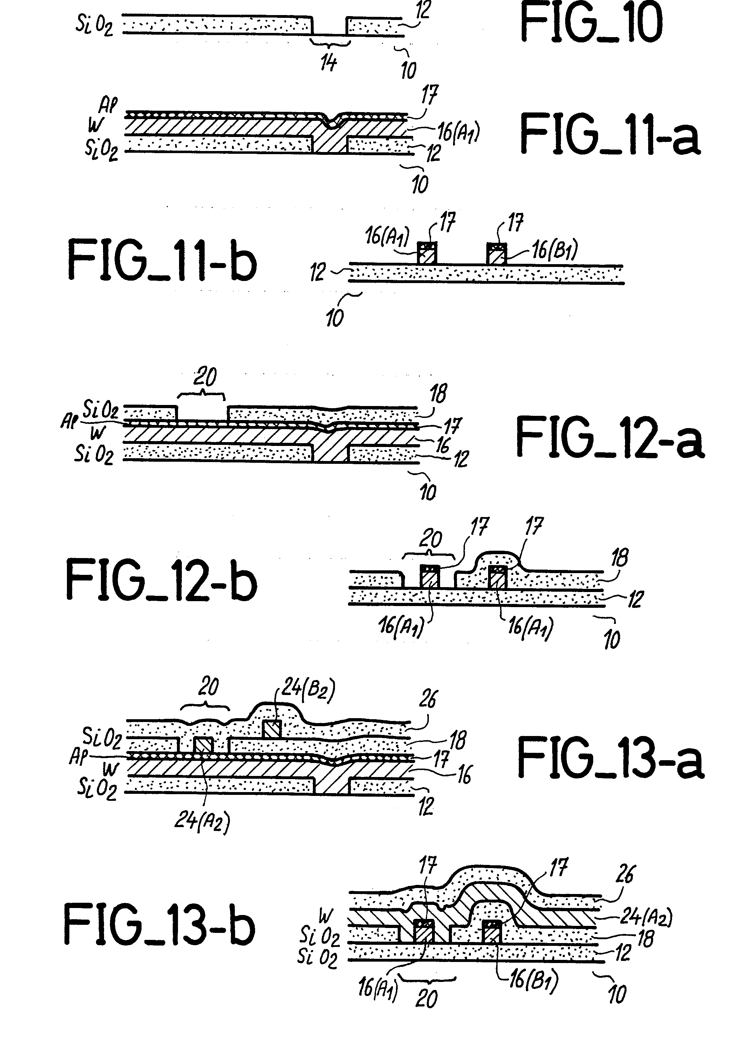

Dans une variante de procédé de fabrication, représentée aux figures 10 à 13, on peut procéder de la manière suivante : comme décrit en référence à la figure 5, on part d'un substrat de circuit intégré 10 qu'on recouvre, après formation d'éléments de circuit non représentés, d'une couche isolante 12 ($SiO_2$) ; cette couche est gravée pour définir des fenêtres 14 en vue d'un contact avec des éléments de circuit sous-jacents (figure 10).

On dépose comme précédemment la première couche de tungstène (ou Ti-W) 16. Au lieu de la graver tout de suite on dépose immédiatement une couche mince 17 constituée essentiellement d'aluminium, analogue à la couche 22 des figures 8 et 9 (épaisseur de quelques dixièmes de microns). Le dépôt s'effectue dans le même bâti de pulvérisation que le premier dépôt de tungstène. Avec un masque de résine définissant le premier motif d'interconnexions, on effectue une gravure sèche sélective de l'aluminium, à partir d'un composé chloré ($CCl_4$ par exemple). Avec le même masque, on grave ensuite le tunsgtène de la couche 16 à partir d'un composé fluoré ($SF_6$, etc...), par gravure anisotrope verticale (on pourrait d'ailleurs envisager d'éliminer le masque de résine lors de la gravure du tungstène puisque l'aluminium reproduit ce masque et, n'étant pas attaqué par le composé fluoré utilisé, protège le tungstène là où il doit subsister). La figure 11a représente une coupe longitudinale de la structure le long d'une ligne A1 de tungstène ; la figure 11b représente une coupe transversale coupant des lignes A1 et B1 conformément au motif de la figure 1.

On dépose ensuite une couche isolante 18 que l'on grave pour définir des fenêtres de contact débordantes 20 dans lesquelles le

9

tungstène recouvert d'aluminium est mis à nu (figure 12a et 12b en coupes longitudinale et transversale).

On dépose par pulvérisation ou décomposition chimique la deuxième couche de tungstène 24 (ou Ti-W) comme à la figure 8 et on la grave pour définir le deuxième motif d'interconnexion (gravure sèche anisotrope verticale par composé fluoré). Le composé fluoré utilisé (notamment $SF_6$) n'attaque pas la première couche de tungstène dans les fenêtres débordantes 20 car cette première couche est protégée par l'aluminium y compris dans les fenêtres 20. Le circuit peut à nouveau être recouvert d'une couche isolante 26 (cf figure 9) et on aboutit à la structure des figures 13 a (coupe longitudinale) et 13b (coupe transversale le long d'un conducteur de colonne A2 coupant une fenêtre 20).

Dans cette structure à deux niveaux d'interconnexion de tungstène, le premier niveau est partout constitué d'une couche principale de tungstène 16 recouverte d'une couche mince d'aluminium 17.

On réalise ainsi des structures multi-couches d'interconnexion avec un procédé particulièrement simple ne nécessitant pas un accroissement de l'espacement entre lignes de conducteurs.

10

## REVENDICATIONS

1. Procédé de fabrication de circuits intégrés à au moins deux niveaux d'interconnexions métalliques (A1, B1 ; A2, B2) présentant entre eux des zones de contact ponctuelles (Z1), comprenant les étapes suivantes :

a) dépôt d'une première couche d'interconnexion (16) constituée essentiellement par du tungstène,

b) gravure sèche sélective de la première couche (16), à travers un masque ouvert selon un motif d'interconnexion désiré (A1, B1),

c) dépôt d'une couche isolante (18),

d) gravure de cette couche isolante (18) pour ouvrir des fenêtres (20) à l'endroit des zones de contact désirées, les fenêtres étant plus larges que les zones de contact,

e) dépôt d'une deuxième couche d'interconnexion (24) constituée essentiellement par du tungstène,

f) gravure sèche sélective, à partir d'un composé fluoré, de la deuxième couche à travers un masque ouvert selon un autre motif d'interconnexion désiré (A2, B2),

caractérisé en ce que, entre les étapes a) et e), on effectue le dépôt d'une couche mince constituée essentiellement d'aluminium (22, figure 8-9 ; 17 figures 11 à 13).

2. Procédé selon la revendication 1, caractérisé en ce que le dépôt d'aluminium est effectué entre les étapes d) et e), et en ce que l'aluminium (22) qui reste non recouvert par le tungstène de la deuxième couche (24) après la gravure de cette dernière, est éliminé après l'étape f), sans masquage, au moyen d'un produit d'attaque de l'aluminium sélectif par rapport au tungstène et au matériau de la couche isolante déposée à l'étape c).

3. Procédé selon la revendication 1, caractérisé en ce que le dépôt d'aluminium est effectué entre les étapes a) et b) et en ce que

11

la couche d'aluminium (17) est gravée immédiatement après par une gravure sèche à partir d'un composé chloré, à travers le masque de l'étape b) définissant le motif d'interconnexion désiré pour la première couche.

4. Procédé selon l'une des revendications 1 à 3, caractérisé en ce que le tungstène des deux couches est gravé à partir de fluorure de soufre $SF_6$, ou fluorure de carbone $CF_4$, éventuellement additionnés d'oxygène.

5. Procédé selon l'une des revendications 1 à 3, caractérisé en ce que l'aluminium est gravé ou éliminé au moyen de chlorure de carbone $CCl_4$, ou de chlorure de bore ou de chlore ou un mélange de ces gaz.

6. Procédé selon l'une des revendications 1 à 3, caractérisé en ce que l'aluminium est éliminé par gravure chimique dans un bain contenant du $H_3PO_4$.

FIG_1

FIG_2

FIG_3

FIG_4

**FIG_5**

**FIG_6-a**

**FIG_6-b**

**FIG_7-a**

**FIG_7-b**

**FIG_8-a**

**FIG_8-b**

**FIG_9-a**

**FIG_9-b**

0169082

3/3

FIG_10

FIG_11-a

FIG_11-b

FIG_12-a

FIG_12-b

FIG_13-a

FIG_13-b

**Office européen des brevets**

# RAPPORT DE RECHERCHE EUROPEENNE

## DOCUMENTS CONSIDERES COMME PERTINENTS

| Catégorie | Citation du document avec indication. en cas de besoin. des parties pertinentes | Revendication concernee | CLASSEMENT DE LA DEMANDE (Int CI 4) |
|---|---|---|---|
| A | HEWLETT-PACKARD JOURNAL, vol. 34, no. 8, août 1983, pages 30-32, Amstelveen, NL; J.P. ROLAND et al.: "Two-layer refractory metal IC process" * Page 31, colonne de droite, dernier paragraphe; page 32, colonne de gauche * | 1 | H 01 L 21/90 H 01 L 23/52 |
| | --- | | |
| A | US-A-4 289 834 (G.E. ALCORN) * Abrégé * | 1 | |
| | ----- | | |

DOMAINES TECHNIQUES RECHERCHES (Int. Cl.4)

H 01 L

Le présent rapport de recherche a été établi pour toutes les revendications

| Lieu de la recherche | Date d'achèvement de la recherche | Examinateur |
|---|---|---|
| LA HAYE | 27-09-1985 | IRVINE R.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant